# EUROPÄISCHE PATENTSCHRIFT

(11) **EP 4 133 547 B1**
(45) Veröffentlichungstag und Bekanntmachung des Hinweises auf die Patenterteilung: **10.06.2026**
(21) Anmeldenummer: 21716664.4
(22) Anmeldetag: 31.03.2021
(51) Int. Cl.: H01M 50/204, H01M 50/249, G01L 5/00, H01M 10/613, H01M 10/625

(54) **VERFAHREN ZUM BESTIMMEN EINER KRAFT BEIM EINSETZEN EINES BATTERIEMODULS IN EIN BATTERIEGEHÄUSE**
METHOD FOR DETERMINING A FORCE FOR INSERTING A BATTERY MODULE IN A BATTERY HOUSING
PROCÉDÉ DE DÉTERMINATION D'UNE FORCE LORS DE L'INSERTION D'UN MODULE DE BATTERIE DANS UN BOÎTIER DE BATTERIE

(30) Priorität: 07.04.2020 DE 102020109679
(43) Veröffentlichungstag der Anmeldung: 15.02.2023
(73) Patentinhaber: Lisa Dräxlmaier GmbH, 84137 Vilsbiburg (DE)
(72) Erfinder: AUER, Christian, 94428 Eichendorf (DE); RÖMELSBERGER, Michael, 84323 Massing (DE); GROSSE KRABBE, Josef, 80939 München (DE); KOLLMER, Stefan, 84326 Falkenberg (DE)
(86) Internationale Anmeldenummer: PCT/EP2021/058400
(87) Internationale Veröffentlichungsnummer: WO 2021/204617

(56) Entgegenhaltungen:
- CN-A- 109 449 519
- DE-A1- 102012 207 999
- DE-A1- 102017 223 664
- DE-A1- 102018 216 113

## Beschreibung

### Technisches Gebiet

Die vorliegende Erfindung betrifft ein Verfahren zum Bestimmen zumindest einer Kraft beim Einsetzen eines Batteriemoduls in das Batteriegehäuse.

### Stand der Technik

Bei der Montage von Batteriemodulen in einem Batteriegehäuse einer Batterie werden die Batteriemodule in einen Batterierahmen eingebracht und montiert. Anschließend wird das Batteriegehäuse verschlossen, meistens durch Verschraubung oder Verschweißen eines Deckels. Die Batteriemodule umfassen eine Verschaltung einzelner Batteriezellen. Während des Betriebs der Batterie entsteht in den Batteriezellen Wärme, welche abgeführt werden muss; insbesondere über das Batteriegehäuse. Dafür wird vor der Montage der Batteriemodule in dem Batteriegehäuse auf den Batterierahmen eine Wärmeleitpaste aufgebracht, die die Wärmeleitfähigkeit zwischen dem Batteriemodule und dem Batteriegehäuse sicherstellt beziehungsweise erhöht. Die Batteriemodule werden dann auf den Batterierahmen verpresst, wobei die pastöse Wärmeleitpaste dabei teilweise verdrängt wird, und anschließend die Batteriemodule mit dem Batterierahmen verschraubt. Bei der Montage entstehen während des Verpressens und Verschraubens des Batteriemoduls hohe Montagekräfte, welche derzeit über eine Druckmessfolie, wie beispielsweise eine Fuji Film Folie gemäß der US 6,742,472 B1, gemessen werden können, wobei mit der Druckmessfolie jeweils nur die Gesamtkräfte beim Verpressen oder beim Verschrauben des Batteriemoduls messbar sind. Um die gemessenen Kräfte auszuwerten, muss ein Anwender das Batteriemodule wieder aus dem Batteriegehäuse entfernen und die Intensitäten der Verfärbungen auf den einzelnen Druckmessfolien auswerten, wobei die Verfärbungen entsprechenden Gesamtkräften während des Verpressens und Verschraubens des Batteriemodules zuzuordnen sind. Daher kann über die Druckmessfolien kein zeitlicher Kraftverlauf während dem Verpressen oder Verschrauben der Batteriemodule gemessen werden. Anschließend wird das Batteriemodule wieder in das Batteriegehäuse eingebracht und basierend auf den mittels der Druckmessfolie ermittelten Gesamtkräften verschraubt, so dass die inneren Spannungen in den Batteriezellen des Batteriemodules und des Batterierahmens auf ein Minimum reduziert werden und somit eine lange Lebensdauer der Batteriemodule sichergestellt ist.

So beschreibt die DE 102019 101 403 ein Verfahren zum Vermessen zumindest eines Abschnitts eines Batteriemoduls und eines Abschnitts des Batteriegehäuses durch Ermitteln einer Größe und Form eines Spalts, welcher sich in der bestimmungsgemäßen Einbaulage des Batteriemoduls ergibt. Danach wird die Menge einer Wärmeleitmasse auf Basis der ermittelten Größe und Form des Spalts ermittelt und anschließend in das Batteriegehäuse eingebracht. Hierdurch wird sichergestellt, dass beim Einsetzen des Batteriemoduls in das Batteriegehäuse die optimale Menge an Wärmeleitmasse vorhanden ist und damit die Kräfte beim Verpressen und beim Verschrauben des Batteriemoduls im Batteriegehäuse reduziert werden.

Da diese herkömmlichen Verfahren zur Auswertung der Gesamtkräfte während des Verpressens und Verschraubens des Batteriemodules auf den Batterierahmen des Batteriegehäuses bereits sehr zeitaufwendig im Rahmen des Produktionsprozesses sind, werden derzeit ebenfalls nicht die Kräfte während der endgültigen Verschraubung des Deckels auf das Batteriegehäuse betrachtet.

Die DE 10 2012 207 999 A1 offenbart eine Hüllfolie für ein galvanisches Element. Die Hüllfolie weist mindestens einen Kraftsensor zum Erfassen eines Dehnungszustands der Hüllfolie auf.

Die CN 109 449 519 A offenbart eine Vorrichtung zur Erkennung von Lithium-Ionen-Batterien.

### Beschreibung der Erfindung

Eine Aufgabe der Erfindung ist es daher, unter Einsatz konstruktiv möglichst einfacher Mittel eine verbesserte Kräftemessung während einem Montageprozess von Batteriemodulen in einem Batteriegehäuse aufzuzeigen.

Die Aufgabe wird durch die Gegenstände des unabhängigen Anspruchs gelöst. Vorteilhafte Weiterbildungen der Erfindung sind in den abhängigen Ansprüchen, der Beschreibung und den begleitenden Figuren angegeben.

Ein Aspekt der Offenbarung betrifft ein Kraftmessmodul zum Erfassen einer Kraft beim Einsetzen eines Batteriemoduls in ein Batteriegehäuse, mit einem Gehäuse, das im Wesentlichen die äußeren Abmessungen und Form des Batteriemoduls aufweist; und wenigstens einem Kraftsensor, der in dem Gehäuse angeordnet und eingerichtet ist, eine Kraft beim Einsetzen des Gehäuses in das Batteriegehäuse zu erfassen. Beim Einsetzen des Gehäuses in das Batteriegehäuses wird das Kraftmessmodul zum Beispiel in ein Batteriefach des Batteriegehäuses verpresst. Dadurch entstehen Kräfte, welche von dem Kraftsensor gemessen werden. Beispielsweise kann auch ein zeitlicher Kraftverlauf während dem Verpressen von den Kraftsensoren gemessen werden. Das Kraftmessmodul gemäß der vorliegenden Patentanmeldung wird als eine Art Ersatz für das tatsächlich einzubringende Batteriemodule während eines ersten Press- und Schraubvorgangs verwendet, so dass genauer die auftretenden Kräfte, und insbesondere deren zeitlicher Verlauf, im Vergleich zu herkömmlichen Verfahren durch den Kraftsensor gemessen werden können. Danach ist das Kraftmessmodul leicht wieder aus dem Batteriegehäuse entnehmbar und die gemessenen Kräfte können leicht ausgelesen und im Rahmen des Produktionsprozesses verwendet werden. Die Verwendung einer Druckmessfolie ist gemäß dem vorliegenden Verfahren ebenfalls nicht mehr notwendig. Nach der Entnahme des Kraftmessmoduls kann das entsprechende Batteriemodul in das Batteriegehäuse eingebracht und unter Berücksichtigung der gemessenen Kräfte mittels des Kraftmessmodules endgültig verpresst und verschraubt werden, wobei die dabei auftretenden inneren Spannungen innerhalb der Batteriezellen im jeweiligen Batteriemodul und innerhalb des Batteriegehäuses minimiert werden.

Das Kraftmessmodul umfasst einen Deckel, ein Mittelteil und eine Bodenfläche. Weiterhin umfasst das Kraftmessmodul einen Messverstärker. Der Messverstärker kann über eine Drahtlosschnittstelle mit einer Datenverarbeitungseinheit verbunden sein und erlaubt eine erhöhte Messgenauigkeit der Kraftsensoren, wodurch die von den Kraftsensoren gemessenen Werte besser analysiert werden können. Beispielsweise kann der Messverstärker an dem Mittelteil des Kraftmessmoduls angeordnet sein. Das Mittelteil kann ebenso einen Wippschalter zum Ein- und Ausschalten des Kraftmessmoduls, einen wechselbaren Akku zur elektrischen Energieversorgung, und Wärmetauscher zur Wärmeabfuhr des Kraftmessmoduls umfassen. Der Deckel schützt das Kraftmessmodul vor Beschädigungen und Verschmutzungen. Das Kraftmessmodul ist vorzugsweise als ein autarkes System mit eigener Energieversorgung und eigenen Messsystem ausgestaltet, so dass eine kontinuierliche Verwendung des Kraftmessmoduls im Rahmen des Produktionsprozesses möglich ist.

Da die Formen und äußeren Abmessungen der einzelnen Batteriemodule innerhalb gewisser Toleranzgrenzen variieren, wird des Weiteren vorgeschlagen, das jeweils einzusetzende Batteriemodul bezüglich Form und äußeren Abmessungen zu vermessen, und die Form und die äußeren Abmessungen des Gehäuses des Kraftmessmoduls auf die Form und äußeren Abmessungen des jeweils einzusetzenden Batteriemoduls anzupassen. Hierzu sind vorzugsweise im Boden, im Deckel und/oder in den Seitenwänden des Kraftmessmoduls Schienen angeordnet, die mit korrespondierenden Halterungen und Befestigungen an den Seitenwänden im Boden und/oder im Deckel des Kraftmessmoduls verbindbar sind und damit in flexibler Art und Weise eine Anpassung an unterschiedliche Formen und äußeren Abmessungen des Gehäuses des Kraftmessmoduls ermöglicht. Die Einstellung der Form und äußeren Abmessungen des Gehäuses kann dabei manuell durch einen Bediener durch Arretierung der Halterungen auf der jeweiligen Schiene bzw. durch elektrische Stellmotoren mittels einer elektrischen Steuerung vorgenommen werden.

Hierdurch ist sichergestellt, dass die mit dem Kraftmessmodul gemessenen Kräfte und Kräfteänderungen tatsächlich und sehr genau den Kräfte und Kräfteänderungen während des nachfolgenden Verpressens oder Verschraubens des zugeordneten Batteriemoduls im Batteriegehäuse bzw. während des Verschraubens des Deckels auf dem Batteriegehäuse entsprechen. Aufgrund der genauen Kenntnis der zu erwartenden Kräfte und Kräfteänderungen während des Verpressens und des Verschraubens können die Press- und Schraubkräfte des zugeordneten Batteriemoduls genau vorherbestimmt und angewendet werden. Durch die Anwendung der gerade notwendigen Press- und Schraubkräfte beim Einbringen des Batteriemoduls werden die inneren Spannungen innerhalb des Batteriemoduls und innerhalb des Batteriegehäuses auf ein Minimum reduziert und damit die Lebensdauer der Batterie verlängert.

An dem Gehäuse bzw. innerhalb des Kraftmessmoduls sind mehrere Kraftsensoren angeordnet, um die Kraft an mehreren Stellen messen zu können. Um exakte Messwerte zu erhalten kann die Anordnung der Kraftsensoren so gewählt werden, sodass das Kraftmessmodul statisch bestimmt ist. Ein resultierende Kraft kann dann über einen Schwerpunkt des Kraftmessmoduls berechnet werden. Um Messfehler zu vermeiden, können beispielsweise die Kraftsensoren in einem möglichst flächendeckendem Dreieck angeordnet sein.

Alternativ können die Kraftsensoren an kraftsensitiven Punkten innerhalb des Kraftmoduls angeordnet. Beispielsweise ist vorgesehen, dass die Kraftsensoren auf der auf der gegenüberliegenden Seite des Gehäuses des Kraftmessmoduls hinsichtlich der Schraubdome bzw. Schraubkanäle angeordnet sind, in die die Schrauben verschraubt werden. Um die Schraubdome bzw. die Schraubkanäle bilden sich während des Verschraubens konzentrierte Spannungen, die sich auf das Batteriemodul bzw. das Batteriegehäuse übertragen und innere Spannungen erzeugen. Es ist im Sinne der vorliegenden Patentanmeldung ebenfalls vorgesehen, Kraftsensoren in den Bereichen des Kraftmessmoduls anzuordnen, in denen die größten inneren Spannungen während des Verpressens und Verschraubens zu erwarten sind.

Das Kraftmessmodul umfasst weiterhin mindestens einen Wärmetauscher, beispielsweise einen Ventilator, welcher die durch den Betrieb erzeugte Wärme aus dem Kraftmessmodul abführt. Dadurch wird auch sichergestellt, dass die Temperatur des Kraftmessmoduls die Messung der Kraftsensoren nicht beeinflusst und auf die Temperatur während des Verpressen und Verschraubens des Batteriemoduls einstellbar ist, sodass keine zusätzlichen temperaturinduzierten Kräfte während der Messung durch das Kraftmessmodul im Vergleich zum Verpressen und Verschrauben des zugeordneten Batteriemoduls auftreten.

Ferner ist der Kraftsensor in einer Bodenfläche anordbar und in das Batteriegehäuse einlegbar. In der Bodenfläche können auch mehrere Kraftsensoren angeordnet sein. Der Kraftsensor kann über eine Schulterschraube an der Bodenfläche angeordnet werden. Der Kraftsensor ist an dem Mittelteil des Kraftmessmoduls fixierbar. Weiterhin kann der Kraftsensor eine gehärtete Oberfläche aufweisen. Bei der Messung der Kräfte wird das Gewicht des Kraftsensors und/oder des Kraftmessmoduls während der Messung nicht berücksichtigt, sodass ausschließlich die tatsächlich durch das Verpressen und/oder Verschrauben auftretenden Kräfte und Kräfteänderungen gemessen werden.

Gemäß einem bevorzugten Beispiel der Offenbarung umfasst das Kraftmessmodul mindestens zwei Kraftsensoren, die räumlich verteilt in dem Gehäuse angeordnet sind und jeweils eingerichtet sind, die Kraft beim Einsetzen des Gehäuses in das Batteriegehäuse zu erfassen. Durch eine Anordnung mehrerer Kraftsensoren an dem Gehäuse kann die Kraft an mehreren Stellen gemessen werden. Durch nachfolgende Auswertungen können entweder die Kräfte und Kräfteänderungen bezogen auf die jeweiligen Positionen der Kraftsensoren ausgewertet oder mittels mathematischer Funktionen bezogen auf bestimmte Flächen des Kraftmessmoduls ausgewertet werden, beispielsweise durch Mittelung der Kräfte an drei Punkte über die Fläche zwischen den drei Punkten.

Um eine Planparallelität zwischen der Bodenfläche und dem Mittelteil zu erhalten, können die Bodenfläche und das Mittelteil nach einem Zusammenbau des Kraftmessmoduls noch einmal plan gefräst werden. Das Material von Kontaktflächen der Sensoren mit dem Mittelteil kann verschleißfreier und rostfreier Stahl sein. Flächen, bei denen das Kraftmessmodul verschraubt ist, können ebenfalls aus verschleißfreiem und rostfreiem Stahl bestehen. Beispielsweise kann der Deckel des Kraftmessmoduls aus Aluminium sein. Um das Gewicht des Kraftmessmoduls so gering wie möglich zu halten, kann der Stahl mit Aussparungen versehen sein.

Ferner weist das Gehäuse eine Anordnung auf, die eingerichtet ist, das Kraftmessmodul mit dem Batteriegehäuse und/oder mit einem Deckel zu verschrauben, wobei der wenigstens eine Kraftsensor eingerichtet ist, eine Kraft auf das Kraftmessmodul beim Verschrauben des Kraftmessmoduls mit dem Batteriegehäuse und/oder dem Deckel zu erfassen.

Gemäß einem weiteren bevorzugten Beispiel der Offenbarung umfasst das Kraftmessmodul eine Datenverarbeitungseinrichtung, die eingerichtet ist, ein Kraftsensorsignal des wenigstens einen Kraftsensors zu erfassen und auszuwerten. Die Datenverarbeitungseinrichtung kann über ein Datennetz, zum Beispiel Ethernet, mit dem Messverstärker verbunden sein. Das Kraftsensorsignal kann in Echtzeit von der Datenverarbeitungseinrichtung aufgenommen und ausgewertet werden. Ebenso kann die Datenverarbeitungseinrichtung den zeitlichen Kraftverlauf beim Verpressen oder Anschrauben des Kraftmessmoduls aufnehmen und auswerten.

Weiterhin umfasst das Kraftmessmodul eine Drahtlosschnittstelle, insbesondere eine WLAN-Schnittstelle, die eingerichtet ist, Daten von dem Kraftmessmodul an eine weitere Datenverarbeitungseinrichtung zu übertragen. Beispielsweise kann die weitere Datenverarbeitungseinrichtung ein externer Computer sein, welcher von einem Anwender bedient wird. Die Drahtlosschnittstelle kann in dem Mittelteil des Kraftmessmoduls angeordnet. Eine signaldurchlässige Kunststoffverdeckung schützt die Drahtlosschnittstelle vor Beschädigungen und Schmutz. Durch die Drahtlosschnittstelle kann das Kraftmessmodul komfortabel von dem Anwender bedient werden. Ebenfalls können über die Drahtlosschnittstelle die Messdaten des Kraftmessmoduls an ein externes Schraubterminal versendet werden, auf deren Grundlage die Schraubparameter für das korrespondierende Batteriemodul automatisch voreingestellt und dann während des halbautomatischen oder automatischen Verpress- und Schraubprozesses verwendet werden kann.

Gemäß einem weiteren bevorzugten Beispiel der Offenbarung umfasst das Kraftmessmodul eine Aufnahme mit einem Energiespeicher, der eingerichtet ist, das Kraftmessmodul mit elektrischer Energie zu versorgen. Beispielsweise kann der Energiespeicher ein wechselbarer Akku sein. Der Akku kann das Kraftmessmodul mit einer Spannung, vorzugsweise von 12 Volt, versorgen. Zudem kann das Kraftmessmodul zum Beispiel über ein Netzteil betrieben werden. An dem wechselbaren Akku können die Wärmetauscher nebeneinander angeordnet sein. Über ein Warnsignal, beispielsweise eine Warnlampe oder ein Warndisplay, kann der Anwender erkennen, ob der Akku zu wechseln ist. So kann vermieden werden, dass das Kraftmessmodul wegen mangelnder Energieversorgung die Messung unterbricht.

Ein Aspekt der Erfindung betrifft ein Verfahren zum Bestimmen einer Kraft beim Einsetzen eines Batteriemoduls in ein Batteriegehäuse, mit einem Bereitstellen eines Kraftmessmoduls mit einem Gehäuse, das im Wesentlichen die äußeren Abmessungen des Batteriemoduls aufweist; und wenigstens einem Kraftsensor, der in dem Gehäuse angeordnet und eingerichtet ist, eine Kraft beim Einsetzen des Gehäuses in das Batteriegehäuse zu erfassen, einem Einsetzen des Kraftmessmoduls anstatt des Batteriemoduls in das Batteriegehäuse und einem Erfassen der Kraft beim Einsetzen durch den Kraftsensor.

Beispielsweise kann das Kraftmessmodul mittels einem Werkstückgreifer in das Batteriefach des Batteriegehäuses eingesetzt werden. Vor dem Einsetzen des Kraftmessmoduls kann in dem Batteriefach eine Wärmeleitmedium, wie beispielsweise ein Gapfiller, aufgetragen werden. Das Kraftmessmodul kann dann in dem Batteriefach verpresst werden.

In einer bevorzugten Ausführungsform werden die Form und äußeren Abmessungen des jeweils einzusetzenden Batteriemoduls vermessen, und die Form und die äußeren Abmessungen des Gehäuses des Kraftmessmoduls auf die Form und äußeren Abmessungen des jeweils einzusetzende Batteriemodule angepasst. Hierzu werden vorzugsweise der Boden, Deckel und/oder die Seitenwänden des Kraftmessmoduls dergestalt gegeneinander verschoben und arretiert, so dass eine flexible Anpassung an unterschiedliche Formen und äußeren Abmessungen des Gehäuses des Kraftmessmoduls ermöglich sind. Die Einstellung der Form und äußeren Abmessungen des Gehäuses kann dabei manuell durch einen Bediener durch Arretierung der Halterungen auf der jeweiligen Schiene bzw. durch elektrische Stellmotoren mittels einer elektrischen Steuerung vorgenommen werden.

Zum Beispiel kann das Kraftmessmodul drei Kraftsensoren aufweisen, welche in der Bodenfläche räumlich verteilt angeordnet sind und die Kraft beim Verpressen des Kraftmessmoduls erfassen. Die Messwerte können dann von der Datenverarbeitungsausrichtung aufgenommen und analysiert werden. Nach dem Erfassen der Kraft kann das Kraftmessmodul mittels dem Werkstückgreifer aus dem Batteriefach entnommen werden und ein Batteriemodul wird in das Batteriefach eingesetzt.

Ferner wird eine Kraft bei einem Anschrauben des eingesetzten Kraftmessmoduls an das Batteriegehäuse und/oder an einen Deckel erfasst. Das Anschrauben des Batteriemoduls, basierend auf den ermittelten Kräften und Kräfteänderungen im Kraftmessmodul, kann über den Werkstückgreifer oder ein Schraubterminal erfolgen.

Ferner kann neben einer Messung und Auswertung von Verpress- und Anschraubkräften auch eine Benetzung des Wärmeleitmediums in dem Batteriefach während dem Verpressen und Anschrauben des Kraftmessmoduls analysiert werden.

Gemäß der Erfindung wird das eingesetzte Kraftmessmodul entfernt und das Batteriemodul in das Batteriegehäuse, unter Berücksichtigung der zuvor gemessenen Kräfte auf das eingesetzte Kraftmessmodul, eingesetzt. Das Batteriemodul kann mit dem Werkstückgreifer eingesetzt werden.

Weitere Merkmale, Vorteile und Einzelheiten der Erfindung ergeben sich aus der nachfolgenden Beschreibung eines bevorzugten Ausführungsbeispiels sowie anhand der Zeichnungen.

### Kurze Figurenbeschreibung

Die Erfindung wird im Folgenden anhand von Ausführungsbeispielen und den Figuren näher erläutert. In den Figuren zeigen:
- Figur 1: eine Explosionsdarstellung eines Kraftmessmoduls gemäß einem ersten Beispiel der Offenbarung;
- Figur 2: eine perspektivische Darstellung eines Kraftmessmoduls gemäß dem ersten Beispiel der Offenbarung;
- Figur 3: eine perspektivische Darstellung eines Kraftmessmoduls mit einem Batteriefach gemäß dem ersten Beispiel der Offenbarung;
- Figur 4: eine Schnittdarstellung einer Bodenfläche mit einem Kraftsensor und einem Mittelteil gemäß einem zweiten Beispiel der Offenbarung während einem Verpressen des Kraftmessmoduls;
- Figur 5: eine schematische Darstellung eines Verfahrens zum Bestimmen einer Kraft beim Einsetzen eines Batteriemoduls in ein Batteriegehäuse.

Die Figuren sind lediglich schematische Darstellungen und dienen nur der Erläuterung der Erfindung. Gleiche oder gleichwirkende Elemente sind durchgängig mit den gleichen Bezugszeichen versehen.

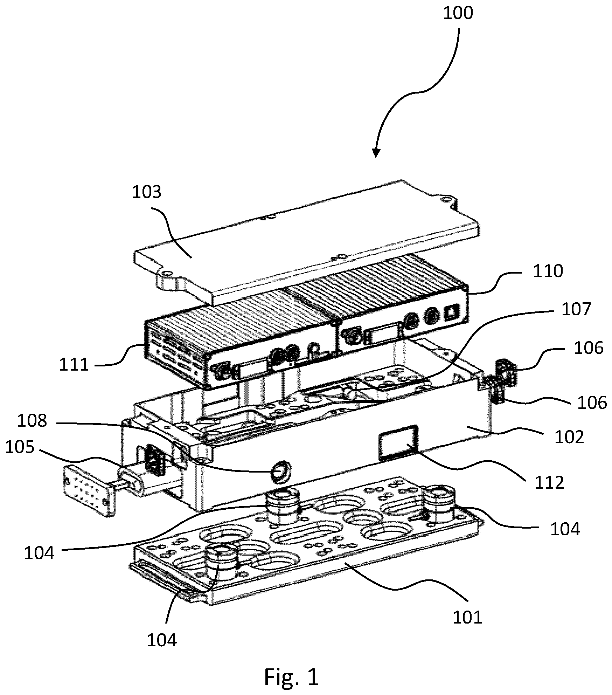

Die Fig. 1 zeigt ein Kraftmessmodul gemäß einem ersten Beispiel der Offenbarung in einer Explosionsdarstellung.

Das Kraftmessmodul 100 umfasst eine Bodenfläche 101. Gemäß dem erstem Beispiel der Offenbarung ist die Bodenfläche über drei Kraftsensoren 104 mit einem Mittelteil 102 verbunden. Die drei Kraftsensoren 104 sind dreiecksförmig an der Bodenfläche 101 angeordnet und an dem Mittelteil 102 befestigt. In Rahmen einer Auswertung der an den Kraftsensoren 104 gemessenen Kräfte und Kräfteänderungen, kann eine räumliche Spannungsverteilung basierend auf der Mittelung der jeweiligen Kräfte und Kräfteänderungen bezogen die Fläche zwischen und bezogen auf die Positionen der Kraftsensoren 104 berechnet werden. In einem weiteren Beispiel der Offenbarung sind mehr als drei Kraftsensoren 104 an der Bodenfläche 101 anders räumlich verteilt angeordnet, wobei unterschiedlichste räumliche Verteilungen denkbar sind und entsprechende Auswertemethoden an den Positionen der Kraftsensoren 104 ermöglichen.

An dem Mittelteil 102 ist ein wechselbarer Akku 105 angeordnet, welcher das Kraftmessmodul 100 mit elektrischer Energie versorgt. Über ein Warndisplay 112, welches ebenso an dem Mittelteil 102 angeordnet ist, wird angezeigt, wann der Akku 105 zu wechseln ist. Zwei Ventilatoren als Wärmetauscheinheiten 106 sind ebenfalls an dem Mittelteil 102 angeordnet und befestigt. In einem weiteren Beispiel der Offenbarung sind mehr als zwei Ventilatoren 106 an dem Mittelteil 102 befestigt. Die Ventilatoren 106 schützen das Kraftmessmodul 100 vor Überhitzung und leiten die während dem Betrieb erzeugte Wärme ab oder halten die Temperatur des Kraftmessmoduls 100 auf einer vorbestimmten Temperatur; vorzugsweise auf der Temperatur des zugeordneten Batteriemodules 113 (nicht in Fig. 1 dargestellt) während des Verpressens und Verschraubens.

Weiterhin sind an dem Mittelteil 102 ein Ein/Aus-Wippschalter 108 und eine Drahtlosschnittstelle 107 angeordnet. Der Ein/Aus-Wippschalter 108 dient zum Ein- und Ausschalten des Kraftmessmoduls 100; vorzugsweise im Rahmen einer automatisierten Einbringung des Kraftmessmoduls 100 in ein Batteriegehäuse. Gemäß dem ersten Beispiel der Offenbarung ist die Drahtlosschnittstelle 107 eine WLAN-Schnittstelle. Über die Drahtlosschnittstelle 107 lässt sich das Kraftmessmodul mit einer externen Datenverarbeitungseinrichtung verbinden.

Weiterhin ist eine weitere Datenverarbeitungseinrichtung 111 in dem Mittelteil 102 verbaut und mit einem Messverstärker 110 über ein Datennetz verbunden. Die Datenverarbeitungseinrichtung 111 nimmt die von den Kraftsensoren 104 jeweils gemessenen Messwerte in Echtzeit auf, analysiert diese und berechnet die resultierenden Kräfte und/oder Kraftänderungen. Anhand der berechneten Kräfte und/oder Kräfteänderungen werden Aussagen über die Qualität und auftretenden innere Spannungen beim Anpressen und Verschrauben des Kraftmessmoduls 100 getroffen. Der Messverstärker 110 ist ebenfalls an dem Mittelteil 102 angeordnet. Durch den Messverstärker 110 wird die Messgenauigkeit der Kraftsensoren 104 erhöht.

Das Kraftmessmodul 100 umfasst ferner einen Deckel 103, welcher das Kraftmessmodul 100 vor Beschädigungen und Schmutz schützt.

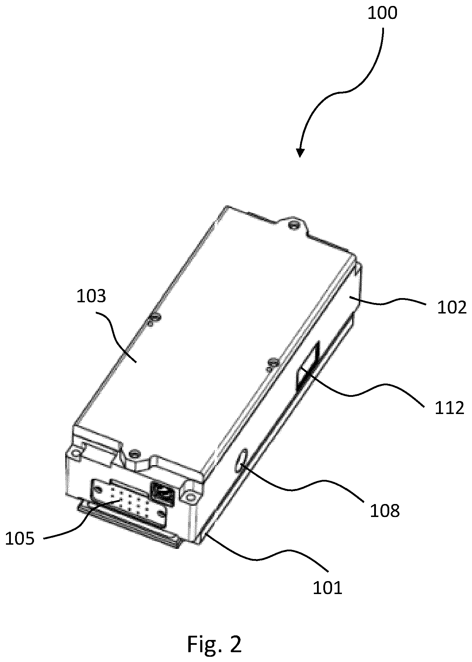

Die Fig. 2 zeigt das Kraftmessmodul in einer perspektivischen Darstellung gemäß dem ersten Beispiel der Offenbarung.

Die Bodenfläche 101, das Mittelteil 102 und der Deckel 103 des Kraftmessmoduls 100 sind über Schrauben befestigt. Das Gehäuse des Kraftmessmoduls 100 entspricht der Form und den äußeren Abmessungen des einzusetzenden Batteriemoduls 113.

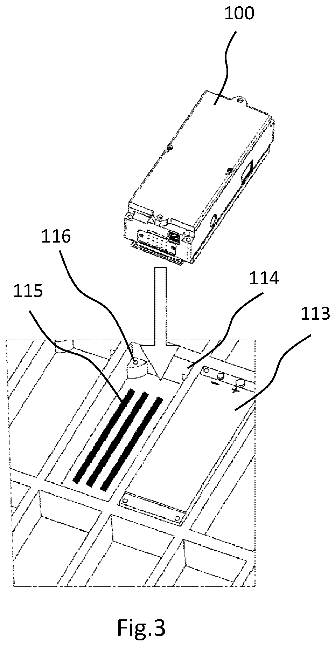

Die Fig. 3 zeigt das Kraftmessmodul mit einem Batteriefach 114 gemäß dem ersten Beispiel der Offenbarung in einer perspektivischen Darstellung.

Die Bodenfläche 101 des Kraftmessmoduls 100 ist in dem Batteriefach 114 schwimmend gelagert, da vor dem Einpressen das Kraftmessmoduls 100 ein Gapfiller 115 in dem Batteriefach 114 aufgetragen wird. Im gezeigten Beispiel wird der Gapfiller 115 streifenförmig auf den Boden des Batteriefachs 114 eingetragen. Das Batteriefach 114 umfasst mehrere Anschraublaschen 116. Das Kraftmessmodul 100 wird mithilfe der Anschraublaschen 116 an das Batteriegehäuse angeschraubt. Dabei kann das Kraftmessmodul 100 jeweils einzeln in ein zugeordnetes Batteriefach 114 eingebracht und verschraubt werden, sodass im unmittelbaren Anschluss das zugeordnete Batteriemodul 113 unter Berücksichtigung der gemessenen Kräfte und Kräfteänderungen im Kraftmessmodul 100 verpresst und verschraubt wird. Durch diese Vorgehensweise wird sichergestellt, dass die inneren Spannungen innerhalb des zugeordneten Batteriemoduls 113 des jeweiligen Batteriefachs 114 minimiert werden. Alternativ ist vorgesehen, dass in einem ersten Schritt alle Batteriefächer 114 des Batteriegehäuses jeweils mit Kraftmessmodulen 100 bestückt und verschraubt werden und anschließend die Kraftmessmodule 100 einzeln wieder den Batteriefächern 114 entnommen und durch zugeordnete Batteriemodule 113 ersetzt werden, wobei die jeweiligen Batteriemodule 113 auf der Basis der gemessenen Kräfte und/oder Kräfteänderungen des dem jeweiligen Batteriefach 114 zugeordneten Kraftmessmodul 100 verpresst und verschraubt werden. Vorteil dieser Vorgehensweise ist, dass die inneren Spannungen innerhalb des gesamten Batteriegehäuses, und nicht nur bezogen auf jeweils ein Batteriefach 114, minimiert werden.

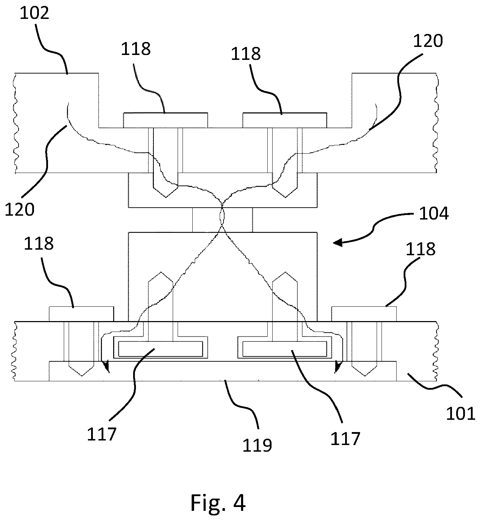

Die Fig. 4 zeigt eine Schnittdarstellung der Bodenfläche mit dem Kraftsensor und dem Mittelteil gemäß einem zweiten Beispiel der Offenbarung während dem Verpressen des Kraftmessmoduls.

Der Kraftsensor 104 ist mit Schrauben 118 an dem Mittelteil 102 befestigt. Gemäß dem zweiten Beispiel der Offenbarung umfasst die Bodenfläche 101 eine Abdeckung 119. Weiterhin ist der Kraftsensor 104 mit Schulterschrauben 117 an der Bodenfläche 101 befestigt. Bei der Schulterschraube 117 ist nur die Spitze des Schraubenhalses mit einem Gewinde versehen. Der restliche Teil des Schraubenhalses weist eine glatte Oberfläche auf, wodurch die Schulterschraube 117 in einem Schraubenloch linear bewegbar ist. Die Bodenfläche 101 ist nur über die Schulterschrauben 117 und den Kraftsensor 104 mit dem Mittelteil 102 verbunden. Bei dem Verpressen des Kraftmessmoduls 100 wird die Schulterschraube 117 in das Schraubenloch gedrückt. Ebenfalls ist in der Fig. 4 der Kraftfluss 120 während dem Verpressen des Kraftmessmoduls 100 in Form von Linien gezeigt. Die Kräfte werden über die Schrauben 118 und dem Kraftsensor 104 übertragen.

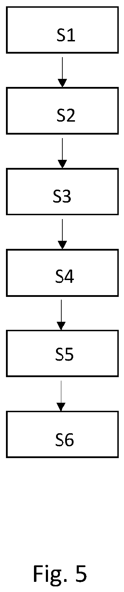

Die Fig. 5 zeigt eine schematische Darstellung eines Verfahrens zum Bestimmen einer Kraft beim Einsetzen eines Batteriemoduls in ein Batteriegehäuse.

In einem ersten Schritt (S1) wird das Kraftmessmodul 100 mit dem Gehäuse bereitgestellt.

Das Kraftmessmodul 100 hat die Form und äußeren Abmessungen des Batteriemoduls 113 beziehungsweise wird an die Form und äußeren Abmessungen des jeweils einzusetzenden Batteriemoduls angepasst.

In einem zweiten Schritt (S2) wird an einer Bodenfläche des Batteriefachs 114 ein Gapfiller 115 aufgetragen.

In einem dritten Schritt (S3) wird das Kraftmessmodul 100 in das Batteriefach 114 des Batteriegehäuses eingesetzt. Das Kraftmessmodul 100 wird mittels einem Werkstückgreifer in das Batteriefach 114 eingesetzt.

In einem vierten Schritt (S4) werden die Kräfte und/oder die Kräfteänderungen beim Einsetzen des Kraftmessmoduls 100 in das Batteriefach 114 von den Kraftsensoren 104 erfasst. Das Kraftmessmodul 100 wird beim Einsetzen in das Batteriefach 114 mit einer Andruckkraft beaufschlagt. An der Bodenfläche 101 des Kraftmessmoduls 100 sind gemäß dem Ausführungsbeispiel drei Kraftsensoren 104 angeordnet. Es werden die einzelnen Kräfte und/oder Kräfteänderungen der jeweiligen Kraftsensoren 104 gemessen. Die Datenverarbeitungseinrichtung 111 nimmt die gemessenen Messwerte in Echtzeit auf und berechnet die resultierende Kraft beim Pressen des Kraftmessmoduls 100 in das Batteriefach 114.

In einem fünften Schritt (S5) werden von den Kraftsensoren 104 die Kräfte beim Anschrauben des Kraftmessmoduls 100 an das Batteriegehäuse und an einen Deckel des Batteriegehäuses erfasst. In einem weiteren Ausführungsbeispiel können die Kräfte beim Anschrauben des Kraftmessmoduls 100 an das Batteriegehäuse oder an einen Deckel des Batteriegehäuse erfasst werden.

In einem sechsten Schritt (S6) wird das Kraftmessmodul 100 aus dem Batteriefach 114 mit einem Werkstückgreifer herausgenommen und anschließend das Batteriemodul 113 in das Batteriegehäuse eingesetzt. Die zuvor gemessenen Messwerte durch die Kraftsensoren 104 des Kraftmessmoduls 100 werden beim Einsetzen des Batteriemoduls berücksichtigt.

### BEZUGSZEICHENLISTE

- 100: Kraftmessmodul
- 101: Bodenfläche
- 102: Mittelteil
- 103: Deckel
- 104: Kraftsensor
- 105: Akku
- 106: Wärmetauscheinheit
- 107: Drahtlosschnittstelle
- 108: Ein/Aus-Wippschalter
- 110: Messverstärker
- 111: Datenverarbeitungseinrichtung
- 112: Warndisplay
- 113: Batteriemodul
- 114: Batteriefach
- 115: Gapfiller
- 116: Anschraublasche
- 117: Schulterschraube
- 118: Schraube
- 119: Abdeckung
- 120: Kraftfluss

## Patentansprüche

1. Verfahren zum Bestimmen einer Kraft beim Einsetzen eines Batteriemoduls (113) in ein Batteriegehäuse, mit
Bereitstellen eines Kraftmessmoduls (100) mit einem Gehäuse (S1), das im Wesentlichen die äußeren Abmessungen des Batteriemoduls (113) aufweist; und wenigstens einem Kraftsensor (104), der in dem Gehäuse angeordnet und eingerichtet ist, eine Kraft beim Einsetzen des Gehäuses in das Batteriegehäuse zu erfassen;
Einsetzen des Kraftmessmoduls (100) anstatt des Batteriemoduls (113) in das Batteriegehäuse (S3);
Erfassen der Kraft (S4) beim Einsetzen durch den Kraftsensor (104), wobei das eingesetzte Kraftmessmodul entfernt wird und das Batteriemodul in das Batteriegehäuse, unter Berücksichtigung der zuvor gemessenen Kräfte auf das eingesetzte Kraftmessmodul, eingesetzt wird.

2. Verfahren nach Anspruch 1, umfassend ein Erfassen einer Kraft bei einem Anschrauben des eingesetzten Kraftmessmoduls (100) an das Batteriegehäuse und/oder an einen Deckel (S5).

3. Verfahren nach einem der Ansprüche 1 oder 2, umfassend Ermitteln der Form und äußeren Abmessungen des Batteriemoduls (113) und Anpassen der Form und äußeren Abmessungen des Gehäuses des Kraftmessmoduls (100) an die Form und äußeren Abmessungen des Batteriemoduls (113) vor dem Einsetzen des Kraftmessmoduls (100) in das Batteriegehäuse.

## Claims

1. Method for determining a force during insertion of a battery module (113) into a battery housing, comprising:
providing a force measuring module (100) with a housing (S1) which substantially corresponds to the external dimensions of the battery module (113); and at least one force sensor (104) which is arranged in the housing and configured to detect a force during insertion of the housing into the battery housing;
inserting the force measuring module (100), instead of the battery module (113), into the battery housing (S3);
detecting the force (S4) during insertion by means of the force sensor (104),
wherein the inserted force measuring module is subsequently removed and the battery module is inserted into the battery housing while taking into account the forces previously measured on the inserted force measuring module.

2. Method according to claim 1, comprising detecting a force during screwing of the inserted force measuring module (100) to the battery housing and/or to a cover (S5).

3. Method according to one of claims 1 or 2, comprising determining the shape and the external dimensions of the battery module (113) and adapting the shape and the external dimensions of the housing of the force measuring module (100) to the shape and the external dimensions of the battery module (113) prior to inserting the force measuring module (100) into the battery housing.

## Revendications

1. Procédé de détermination d'une force lors de l'insertion d'un module de batterie (113) dans un boîtier de batterie, comprenant :
fournir un module de mesure de force (100) avec un boîtier (S1) dont les dimensions extérieures correspondent essentiellement aux dimensions extérieures du module de batterie (113) ; et au moins un capteur de force (104) disposé dans le boîtier et configuré pour détecter une force lors de l'insertion du boîtier dans le boîtier de batterie ;
insérer le module de mesure de force (100), au lieu du module de batterie (113), dans le boîtier de batterie (S3) ;
détecter la force (S4) lors de l'insertion au moyen du capteur de force (104), le module de mesure de force inséré étant ensuite retiré et le module de batterie étant inséré dans le boîtier de batterie en tenant compte des forces mesurées précédemment sur le module de mesure de force inséré.

2. Procédé selon la revendication 1, comprenant la détection d'une force lors du vissage du module de mesure de force inséré (100) sur le boîtier de batterie et/ou sur un couvercle (S5).

3. Procédé selon l'une des revendications 1 ou 2, comprenant la détermination de la forme et des dimensions extérieures du module de batterie (113) et l'adaptation de la forme et des dimensions extérieures du boîtier du module de mesure de force (100) à la forme et aux dimensions extérieures du module de batterie (113) avant l'insertion du module de mesure de force (100) dans le boîtier de batterie.
